# EUROPEAN PATENT APPLICATION

(11) **EP 1 580 811 A2**
(43) Date of publication of application: **28.09.2005**
(21) Application number: 05003192.1
(22) Date of filing: 15.02.2005
(51) Int. Cl.: H01L 27/00, H01L 51/20

(54) **Passivation films for organic thin film transistors**

(30) Priority: 26.03.2004 JP 2004090805
(71) Applicant: Hitachi, Ltd., Tokyo 100-8280 (JP)
(72) Inventor: Kawasaki, Masahiro, Tokyo 100-8220 (JP); Imazeki, Shuji, Tokyo 100-8220 (JP); Ando, Masahiko, Tokyo 100-8220 (JP); Sekiguchi, Yoshifumi, Tokyo 100-8220 (JP); Hirota, Shoichi, Tokyo 100-8220 (JP)
(74) Representative: Strehl Schübel-Hopf & Partner

(57) **Abstract**

The present invention aims at providing a high-performance semiconductor device such as display, IC tag, sensor or the like at a low cost by using an organic thin film transistor most members of which can be formed by printing, as a switching element. The present invention relates to a thin film transistor composed of members on a dielectric substrate (101), which are a gate electrode (102), a dielectric film (103), source/drain electrodes (104, 105), and a semiconductor layer (107), wherein on said semiconductor layer (107) there are formed at least two passivation films (108, 109) of a first passivation film (108) capping said semiconductor layer (107) to protect it and a second passivation film (109) covering larger area than that of said first passivation film (108) to protect all of said members.

## Description

### Field of the Invention

The present invention relates to a thin film transistor having improved performances and a semiconductor device using the same. In particular, the present invention relates to a method for preventing deterioration and peeling of a semiconductor formed by use of application techniques and printing techniques.

In accordance with advancement of informatization, attention has been paid to development of a thin and light electronic paper display in place of paper, an IC tag capable of identifying commercial products individually at once, or the like. Currently in these devices, a thin film transistor using amorphous silicon or polycrystalline silicon as a semiconductor is used as a switching element. However, in producing thin film transistors using these silicon type semiconductors, there are problems that production cost is high because of necessity of an expensive apparatus such as plasma chemical vapor deposition apparatus or sputtering apparatus and furthermore that throughput is low because of using many processes such as vacuum process, photolithography, finish and the like.

Therefore, an attention has been paid to an organic thin film transistor using an organic material as a semiconductor layer which can be formed by application method/printing method and which can be provided at a low production cost. As a typical structure of the organic thin film transistor which is suitable for application/printing formation, a bottom-contact structure is disclosed in the undermentioned patent literature 1. In general, the chemical resistance and heat resistance of an organic semiconductor material have been known to be inferior to those of an inorganic semiconductor. However, in the bottom-contact structure an organic semiconductor layer is formed after a gate electrode, a gate dielectric film, and source/drain electrodes are formed on a dielectric substrate, and therefore deterioration of the organic semiconductor layer at the time of forming the electrodes/gate dielectric film can be evaded.

Patent literature 1: JP-A-2000-307172

### Brief Summary of the Invention

When a thin film transistor is used as a switching driving element of a semiconductor device such as display or IC tag, it is necessary to form on the thin film transistor a passivation film having (1) dielectric property, (2) property as a barrier against oxygen, water and the like, (3) mechanical strengths such as abrasion resistance, and the like. A passivation film for an organic transistor can be formed by a dry process such as vacuum deposition method, but a wet process such as spin-coating method/printing method is simpler and cheaper and moreover has an advantage that various organic polymer materials can be used as a passivation film material. Furthermore, a film can be used as a passivation film by applying or heat-printing the film. However, when a passivation film is formed by a wet process such as spin-coating method/printing method, there is fear that a semiconductor film would be deteriorated or peeled physically by an organic solvent dissolving the passivation film material.

Furthermore, in order to improve the yield of the device, it is necessary to wash contaminants attached to a substrate by pure water or the like before said passivation film is formed. However, particularly when a substrate is washed in the state where a semiconductor layer is exposed, there is fear that the semiconductor layer would be peeled physically. Moreover, even when a semiconductor is left as an island by use of a water-soluble resist such as PVA, it is unavoidable that side surfaces of the semiconductor would be exposed.

The objects of the present invention reside in preventing deterioration/peeling of a semiconductor film and in providing a high-performance organic thin film transistor and a semiconductor device using the same.

In order to attain said objects, the present invention has been accomplished. That is, the present invention relates to a thin film transistor composed of members, on a dielectric substrate, which are a gate electrode, a dielectric film, source/drain electrodes, and a semiconductor layer, wherein on said semiconductor layer there are formed at least two passivation films, one of which is a first passivation film capping said semiconductor layer to protect it and another of which is a second passivation film covering larger area than that of said first passivation film to protect all of said members.

In the above paragraph, "capping" means the state of covering not only the top surface but also the side surfaces of the semiconductor layer.

The first passivation film is formed in advance of the formation of the second passivation film and placed between the semiconductor layer and the second passivation film. Anywhere within the substrate there is no other material between said first passivation film and said second passivation film. The semiconductor layer is capped by the first passivation film so that not only the top surface but also the side surfaces are not exposed. Thereby, a solution used for washing the substrate and a solution for applying and forming the second passivation film can be prevented from penetrating into the semiconductor layer.

Furthermore, the first passivation film can be formed by dropping of liquid drops or contact printing/heat printing, and therefore peeling of the semiconductor layer can be reduced highly as compared with formation by spin-coating over the entire substrate. In addition, formation is carried out partly, and therefore the amount of material used can be reduced.

Moreover, by using as the first passivation film a material having a higher adhesion to a groundwork than the semiconductor layer and forming the first passivation film partly, contaminants which are attached to the portion not covered with the first passivation film and which lead to defects of a semiconductor device, can be removed by washing without peeling the semiconductor layer.

Furthermore, when a low molecular weight material such as pentacene is used as the semiconductor layer, it is desirable to use a water-soluble material as the first passivation film. The water-soluble material uses water as a solvent and hence hardly penetrates into the interface between pentacene and a groundwork and the semiconductor layer is not peeled from the groundwork. Moreover, deterioration of the channel portion is scarcely caused. Among water-soluble materials, particularly a light-sensitive material is suitable for the first passivation film, because after curing by ultraviolet ray irradiation it becomes water-insoluble and makes washing of the substrate possible. As a light-sensitive water-soluble material, there is, for example, a polyvinyl alcohol, in which an azido light-sensitive group, is acetal-bonded. A polyvinyl alcohol is inferior in property as a barrier against water and a solution, and therefore water contained in the polyvinyl alcohol is sufficiently removed by heating of the substrate or the like, and then the second passivation film protecting all of the members including the semiconductor layer is formed with silicon oxide, silicon nitride or the like superior in property as a barrier to the polyvinyl alcohol.

When a polymeric material having relatively good adhesion to a groundwork is used as the semiconductor layer, water-insoluble materials such as polyvinyl phenol can be also used as the first passivation film.

Furthermore, the present invention relates to a process for preparing a thin film transistor, characterized by carrying out the following steps by turns:
a step of forming a gate electrode on a dielectric substrate,
a step of forming a gate dielectric film on the substrate,
a step of forming a drain electrode and a source electrode on the substrate,
a step of forming an organic semiconductor by an application method or a printing method on the substrate,
a step of forming a first passivation film capping the organic semiconductor by dropping of liquid drops or contact printing/heat printing on the substrate, and
a step of forming a second passivation film in order to protect all of the above members on the substrate.

Moreover, the present invention relates to a process for preparing a thin film transistor, characterized by carrying out the following steps by turns:
a step of forming a gate electrode on a dielectric substrate,
a step of forming a gate dielectric film on the substrate,
a step of forming an organic semiconductor by an application method or a printing method on the substrate,
a step of forming a drain electrode and a source electrode on the substrate,
a step of forming a first passivation film capping the organic semiconductor by dropping of liquid drops or contact printing/heat printing on the substrate, and
a step of forming a second passivation film in order to protect all of the above members on the substrate.

Furthermore, the present invention relates to a process for preparing a thin film transistor, characterized by carrying out the following steps by turns:
a step of forming a drain electrode and a source electrode on a dielectric substrate,
a step of forming an organic semiconductor by an application method or a printing method on the substrate,
a step of forming a first passivation film capping the organic semiconductor by dropping of liquid drops or contact printing/heat printing on the substrate,
a step of forming a second passivation film in order to protect all of the above members on the substrate, and
a step of forming a gate electrode on the substrate.

Other objects, features and advantages of the invention will become apparent from the following description of the embodiments of the invention taken in conjunction with the accompanying drawings.

### Brief Description of the Drawings

Fig. 1 is the planar structure of the thin film transistor in a working embodiment of the present invention.
Fig. 2 is the sectional structure of the thin film transistor in a working embodiment of the present invention.
Fig. 3 is the planar structure of the thin film transistor in a working embodiment of the present invention.
Fig. 4 is the sectional structure of the thin film transistor in a working embodiment of the present invention.
Fig. 5 is the sectional structure of the thin film transistor in a working embodiment of the present invention.
Fig. 6 is the sectional structure of the thin film transistor in a working embodiment of the present invention.
Fig. 7 shows the pattern diagrams and planar structure of the liquid crystal display in a working embodiment of the present invention.
Fig. 8 is the sectional structure of the liquid crystal display in a working embodiment of the present invention.

### Description of Reference Numerals

- 101:: dielectric substrate
- 102:: gate electrode
- 102':: scanning wiring
- 103:: gate dielectric layer
- 104:: source electrode
- 105:: drain electrode
- 105':: signal wiring
- 106:: monomolecular layer
- 107:: semiconductor layer
- 108:: first passivation film
- 109:: second passivation film
- 401:: picture electrode
- 402:: common wiring
- 403:: common electrode
- 404:: through-hole
- 405:: orientated film

### Detailed Description of the Invention

Hereinafter the working embodiments of the present invention will be described in detail with reference to the drawings.

### Example 1

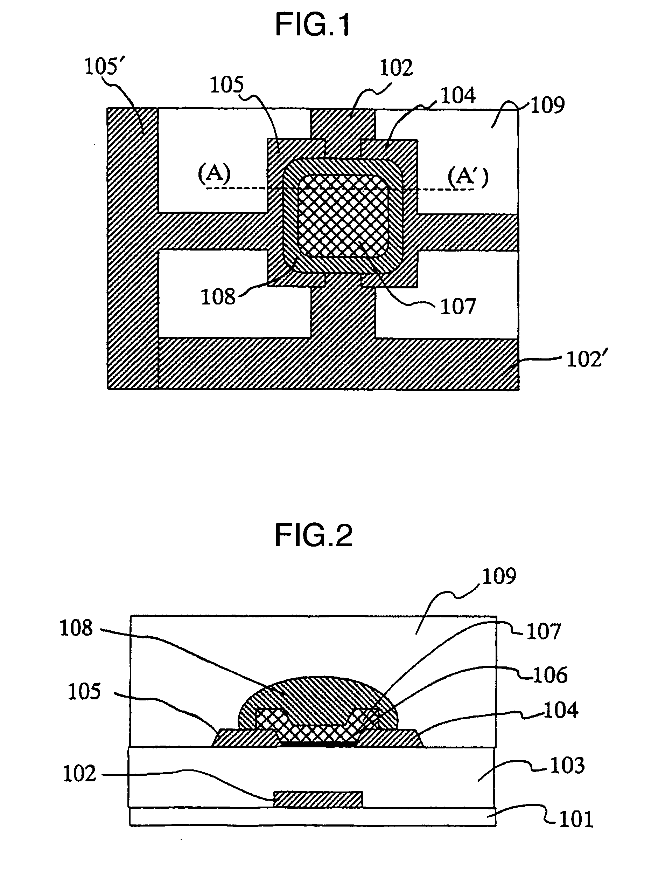

The first example of the present invention is described with reference to Fig. 1 to Fig. 4. Fig. 1 shows the planar schematic view of the organic thin film transistor using the present invention, and Fig. 2 shows the sectional schematic view of the organic thin film transistor using the present invention. Fig. 2 shows the section of (A)-(A') in Fig. 1.

A glass substrate was used as the dielectric substrate 101. The dielectric substrate 101 can be selected from a broad range of dielectric materials. Specifically there can be used inorganic substrates such as quartz, sapphire, silicon and the like; and organic plastic substrates such as acrylic, epoxy, polyamide, polycarbonate, polyimide, polynorbornene, polyphenylene oxide, polyethylene naphthalenedicarboxylate, polyethylene terephthalate, polyethylene naphthalate, polyarylate, polyether ketone, polyether sulfone, polyketone, polyphenylene sulfide and the like. In addition, a film such as silicon oxide, silicon nitride or the like can be provided on the surfaces of these substrates.

Thereon were formed the gate electrode 102 and the scanning wiring 102' of Cr at a thickness of 150 nm. The gate electrode 102 and the scanning wiring 102' are not particularly limited as long as they are conductive materials, and can be formed by a publicly known method such as plasma chemical vapor deposition method, hot vapor deposition method, sputtering method, screen printing method, ink jet method, electrolytic polymerization method, electroless plating method, electroplating method or hot stamping method by use of a metal such as A1, Cu, Ti, Cr, Au, Ag, Ni, Pd, Pt or Ta; a silicon material such as monocrystal silicon or polysilicon; a transparent conducting material such as ITO or tin oxide; an organic conductive material such as polyaniline or poly3,4-ethylenedioxythiophene/polystyrene sulfonate; or the like. The above gate electrode and scanning wiring 102' can be used not only in single layer structure but also in plural layer-laminated structure. Furthermore, the above gate electrode and scanning wiring 102' are processed into desired shapes by use of photolithography method, shadow mask method, microprinting method, laser ablation method or the like.

Next, as the gate dielectric layer 103, SiO₂ film of 300 nm in thickness was formed by chemical vapor deposition (CVD). The gate dielectric layer 103 can be formed by plasma chemical vapor deposition method, hot vapor deposition method, sputtering method, anodic oxidation method, spray method, spin-coating method, roll coating method, blade coating method, doctor roll method, screen printing method, ink jet method or the like by use of an inorganic film such as silicon nitride, aluminium oxide or tantalum oxide; an organic film such as polyvinyl phenol, polyvinyl alcohol, polyimide, polyamide, parylene, polymethylmethacrylate, polyvinyl chloride, polyacrylonitrile, poly(perfluoroethylene-co-butenyl vinyl ether), polyisobutylene, poly(4-methyl-1-pentene), poly(propylene-co-1-butene) or benzocyclobutene resin; or a laminated film thereof.

Next, the source electrode 104/drain electrode 105 and signal wiring 105' of Au were formed at a thickness of 50 nm. The materials of source electrode 104/drain electrode 105 and signal wiring 105' are not particularly limited as long as they are conductive materials, and can be formed by a publicly known method such as plasma chemical vapor deposition method, hot vapor deposition method, sputtering method, screen printing method, ink jet method, electrolytic polymerization method, electroless plating method, electroplating method or hot stamping method by use of a metal such as A1, Cu, Ti, Cr, Au, Ag, Ni, Pd, Pt or Ta; a transparent conducting material such as ITO or tin oxide; an organic conductive material such as polyaniline or poly3,4-ethylenedioxythiophene/polystyrene sulfonate; or the like. The above source/drain electrodes can be used not only in single layer structure but also in plural layer-laminated structure. Furthermore, the above source/drain electrodes are processed into desired shapes by use of photolithography method, shadow mask method, microprinting method, laser ablation method or the like.

Next, the surface of the above gate dielectric layer was modified with the monomolecular layer 106 of octadecyltrichlorosilane. As the monomolecular layer, there can be used a silane compound such as heptafluoroisopropoxypropylmethyldichlorosilane, trifluoropropylmethyldichlorosilane, hexamethyldisilazane, vinyltriethoxysilane, γ-methacryloxypropyltrimethoxysilane, γ-aminopropyltriethoxysilane, N-phenyl-γ-aminopropyltrimethoxysilane, γ-mercaptopropyltrimethoxysilane, heptadecafluoro-1,1,2,2-tetrahydrodecyl-1-trimethoxysilane, octadecyltriethoxysilane, decyltrichlorosilane, decyltriethoxysilane or phenyltrichlorosilane; a phosphonic acid type compound such as 1-phosphonooctane, 1-phosphonohexane, 1-phosphonohexadecane, 1-phosphono-3,7,11,15-tetramethylhexadecane, 1-phosphono-2-ethylhexane, 1-phosphono-2,4,4-trimethylpentane or 1-phosphono-3,5,5-trimethylhexane; or the like. The above modification can be attained by contacting the surface of the gate dielectric layer with the solution or vapor of the above compound to adsorb the compound on the surface of the gate dielectric layer. In addition, it is not essential to modify the surface of the gate dielectric layer with the monomolecular layer 106.

Next, a soluble pentacene derivative was applied by ink jet method and fired at 150°C to form the semiconductor layer 107 of 100 nm in thickness. The semiconductor layer 107 can be formed by hot vapor deposition method, molecular beam epitaxy method, spray method, spin-coating method, roll coating method, blade coating method, doctor roll method, screen printing method, ink jet method or the like by use of a phthalocyanine compound such as copper phthalocyanine, lutetium bisphthalocyanine or aluminium phthalocyanine chloride; a condensed polycyclic aromatic compound such as tetracene, chrysene, pentacene, pyrene, perylene or coronene; a conjugated polymer such as polyaniline, polythienylenevinylene, poly(3-hexylthiophene), poly(3-butylthiophene), poly(3-decylthiophene), poly(9,9-dioctylfluorene), poly(9,9-dioctylfluorene-cobenzothiazole) or poly(9,9-dioctylfluorene-codithiophene); or the like.

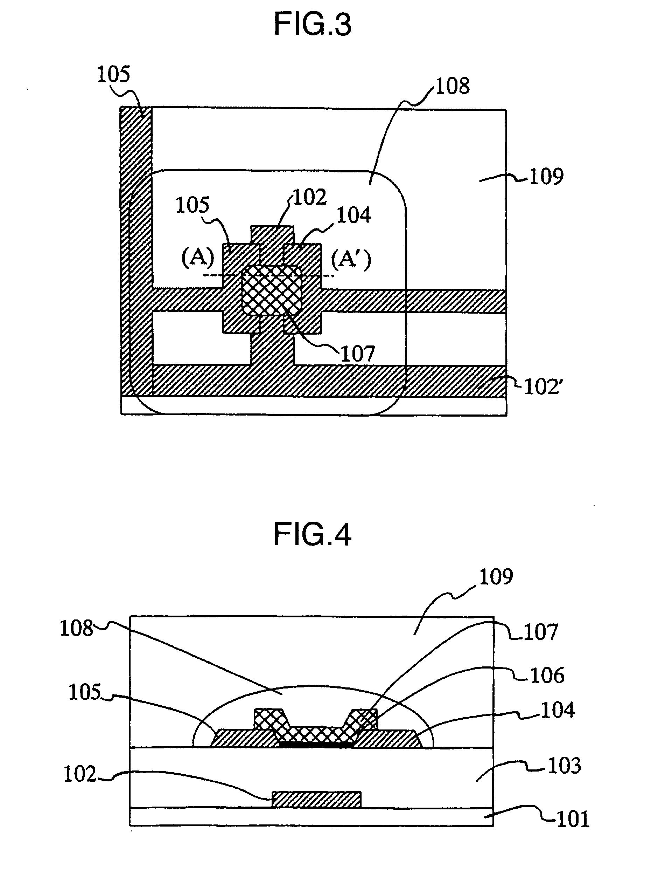

Next, a polyvinyl alcohol, in which an azido light-sensitive group is acetal-bonded, was applied to a portion of the substrate so as to cap the semiconductor layer and irradiated with ultraviolet ray to form the first passivation film 108 of 300 nm in thickness. The first passivation film 108 can be formed by roll coating method, blade coating method, doctor roll method, screen printing method, ink jet method or the like by use of polyvinyl phenol, polyimide, polyamide, parylene, polymethylmethacrylate, polyvinyl chloride, polyacrylonitrile, poly(perfluoroethylene-co-butenyl vinyl ether), polyisobutylene, poly(4-methyl-1-pentene), poly(propylene-co-1-butene), benzocyclobutene resin or the like. In addition, the first passivation film 108 covers also a portion of source electrode 104/drain electrode 105, but in some cases covers the entirety of source electrode 104/drain electrode 105 and a portion of signal wiring 105' depending on the amount of material applied as shown in Fig. 3 and Fig. 4.

Lastly, a solution of silicon oxide was spin-coated so as to cover the whole surface of the substrate and fired at 120°C to form the second passivation film 109 of 300 nm in thickness. The second passivation film 109 can be formed by plasma chemical vapor deposition method, hot vapor deposition method, sputtering method, anodic oxidation method, spray method, spin-coating method, roll coating method, blade coating method, doctor roll method, screen printing method, ink jet method or the like by use of an inorganic film including not only silicon oxide but also silicon nitride and the like; an organic film such as polyvinyl phenol, polyvinyl alcohol, polyimide, polyamide, parylene, polymethylmethacrylate, polyvinyl chloride, polyacrylonitrile, poly(perfluoroethylene-cobutenyl vinyl ether), polyisobutylene, poly(4-methyl-1-pentene), poly(propylene-co-1-butene) or benzocyclobutene resin; or a laminated film thereof.

By providing the first passivation film 108, the peeling of the semiconductor layer 107 caused in the substrate washing before formation of the second passivation film 109 and at the time of forming the second passivation film 109 could be reduced to a value less than 0.1 %.

### Example 2

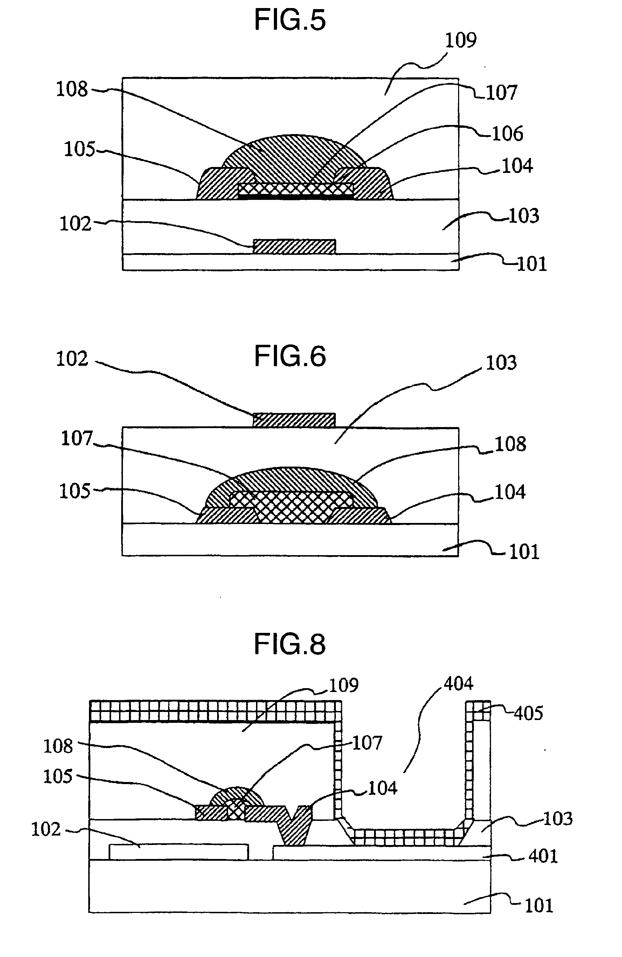

The second example of the present invention is described with reference to Fig. 5. Fig. 5 shows the sectional schematic view of the organic thin film transistor using the present invention. A glass substrate was used as the dielectric substrate 101. The dielectric substrate 101 can be selected from a broad range of dielectric materials similarly to Example 1. Thereon were formed the gate electrode 102 and the scanning wiring 102' of Cr at a thickness of 150 nm. The gate electrode 102 and the scanning wiring 102' are not particularly limited as long as they are conductive materials, and can be selected from a broad range of materials similarly to Example 1. Next, as the gate dielectric layer 103, SiO₂ film of 300 nm in thickness was formed by chemical vapor deposition. The gate dielectric layer 103 can be selected from a broad range of dielectric materials similarly to Example 1. Next, the surface of the above gate dielectric layer was modified with the monomolecular layer 106 of octadecyltrichlorosilane. The monomolecular layer 106 can be selected from a broad range of materials similarly to Example 1. In addition, it is not essential to modify the surface of the gate dielectric layer with the monomolecular layer 106. Next, a soluble pentacene derivative was applied by ink jet method and fired to form the semiconductor layer 107 of 50 nm in thickness. The semiconductor layer 107 can be selected from a broad range of materials similarly to Example 1. Next, the source electrode 104/drain electrode 105 and signal wiring 105' of Au were formed at a thickness of 50 nm. The materials of source electrode 104/drain electrode 105 and signal wiring 105' are not particularly limited as long as they are conductive materials, and can be selected from a broad range of materials similarly to Example 1.

Next, a polyvinyl alcohol, in which an azido light-sensitive group is acetal-bonded, was applied to a portion of the substrate so as to cap the entire semiconductor layer and irradiated with ultraviolet ray to form the first passivation film 108 of 300 nm in thickness. The first passivation film 108 can be selected from a broad range of materials similarly to Example 1. In addition, the first passivation film 108 covers also a portion of source electrode 104/drain electrode 105, but in some cases covers the entirety of source electrode 104/drain electrode 105 and a portion of signal wiring 105' depending on the amount of material applied.

Lastly, a solution of silicon oxide was spin-coated so as to cover the whole surface of the substrate and fired at 120°C to form the second passivation film 109 of 300 nm in thickness. The second passivation film 109 can be selected from not only silicon oxide but also a broad range of materials similarly to Example 1.

By providing the first passivation film 108, the peeling of the semiconductor layer 107 caused in the substrate washing before formation of the second passivation film 109 and at the time of forming the second passivation film 109 could be reduced to a value less than 0.1 %.

### Example 3

The third example of the present invention is described with reference to Fig. 6. Fig. 6 shows the sectional schematic view of the organic thin film transistor using the present invention. A glass substrate was used as the dielectric substrate 101. The dielectric substrate 101 can be selected from a broad range of dielectric materials similarly to Example 1. Thereon were formed the source electrode 104/drain electrode 105 and signal wiring 105' of Au at a thickness of 50 nm. The materials of source electrode 104/drain electrode 105 and signal wiring 105' are not particularly limited as long as they are conductive materials, and can be selected from a broad range of materials similarly to Example 1. Next, a soluble pentacene derivative was applied by ink jet method and fired to form the semiconductor layer 107 of 100 nm in thickness. The semiconductor layer 107 can be selected from a broad range of materials similarly to Example 1.

Next, a polyvinyl alcohol, in which an azido light-sensitive group is acetal-bonded, was applied to a portion of the substrate so as to cap the entire semiconductor layer and irradiated with ultraviolet ray to form the first passivation film 108 of 300 nm in thickness. The first passivation film 108 can be selected from a broad range of materials similarly to Example 1. Next, polyvinyl phenol of 300 nm in thickness was spin-coated to form the gate dielectric layer 103. The gate dielectric layer 103 can be selected from a broad range of dielectric materials similarly to Example 1. Next, the gate electrode 102 and the scanning wiring 102' of aluminium having a thickness of 150 nm were formed by direct painting. The gate electrode 102 is not particularly limited as long as it is a conductive material, and can be selected from a broad range of materials similarly to Example 1.

Lastly, a solution of silicon oxide was spin-coated so as to cover the whole surface of the substrate and fired at 120°C to form the second passivation film 109 of 300 nm in thickness. The second passivation film 109 can be selected from not only silicon oxide but also a broad range of materials similarly to Example 1.

By providing the first passivation film 108, the peeling of the semiconductor layer 107 caused in the substrate washing before formation of the gate dielectric layer 103 and at the time of forming the gate dielectric layer 103 could be reduced to a value less than 0.1 %.

### Example 4

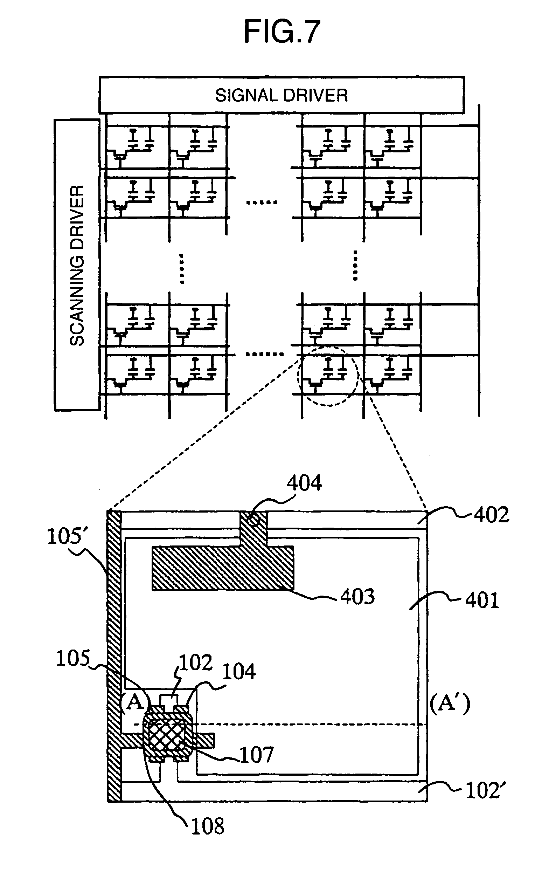

The fourth example of the present invention is described with reference to Fig. 7 to Fig. 8. Fig. 7 shows the pattern diagrams of the liquid display using the present invention and the planar schematic view of the organic thin film transistor using the present invention, and Fig. 8 shows the sectional schematic view of the organic thin film transistor using the present invention. Fig. 8 shows the section of (A) - (A') in Fig. 7.

A glass substrate was used as the dielectric substrate 101. The dielectric substrate 101 can be selected from a broad range of dielectric materials similarly to Example 1. Thereon, the gate electrode 102, the scanning wiring 102', picture electrode 401 and common wiring 402 were formed in the same layer at a thickness of 150 nm with ITO by use of photolithography method. The gate electrode 102, the scanning wiring 102', picture electrode 401 and common wiring 402 are not particularly limited as long as they are conductive materials, and can be formed by a publicly known method such as plasma chemical vapor deposition method, hot vapor deposition method, sputtering method, screen printing method, ink jet method, electrolytic polymerization method, electroless plating method, electroplating method or hot stamping method by use of a metal such as A1, Cu, Ti, Cr, Au, Ag, Ni, Pd, Pt or Ta; a silicon material such as monocrystal silicon or polysilicon; a transparent conducting material such as ITO or tin oxide; an organic conductive material such as polyaniline or poly3,4-ethylenedioxythiophene/polystyrene sulfonate; or the like. The above gate electrode can be used not only in single layer structure but also in plural layer-laminated structure such as a laminate of Cr layer and Au layer or a laminate of Ti layer and Pt layer. Furthermore, the above gate electrode 102, scanning wiring 102', picture electrode 401 and common wiring 402 are processed into desired shapes by use of photolithography method, shadow mask method, microprinting method, laser ablation method or the like.

Next, a light-sensitive resin film of 500 nm in thickness was formed and then fired at 200°C to form the gate dielectric layer 103. The gate dielectric layer 103 can be selected from a broad range of dielectric materials similarly to Example 1. Next, the gate dielectric layer 103 was exposed to light and developed to form the through-hole 404. When the gate dielectric layer 103 is not a light-sensitive material, the through-hole 404 is formed by photolithography method by use of a resist. Next, the source electrode 104/drain electrode 105, the signal wiring 105' and the common electrode 403 were formed at a thickness of 50 nm by applying and firing an ink of Au fine particles, and the source electrode 104 was connected to the picture electrode 401. The materials of source electrode 104/drain electrode 105 and signal wiring 105' are not particularly limited as long as they are conductive materials, and can be selected from a broad range of materials similarly to Example 1. Next, the surface of the above gate dielectric layer was modified with the monomolecular layer 106 of octadecyltrichlorosilane. The monomolecular layer is not particularly limited either and can be selected from a broad range of materials similarly to Example 1. In addition, it is not essential to modify the surface of the gate dielectric layer with the monomolecular layer 106. Next, a soluble pentacene derivative was applied by ink jet method and fired to form the semiconductor layer 107 of 100 nm in thickness. The semiconductor layer 107 is not particularly limited either and can be selected from a broad range of materials similarly to Example 1.

Next, a polyvinyl alcohol, in which an azido light-sensitive group is acetal-bonded, was applied to a portion of the substrate so as to cap the entire semiconductor layer and irradiated with ultraviolet ray to form the first passivation film 108 of 300 nm in thickness. The first passivation film 108 is not particularly limited either and can be selected from a broad range of materials similarly to Example 1. In addition, the first passivation film 108 covers also a portion of source electrode 104/drain electrode 105, but in some cases covers the entirety of source electrode 104/drain electrode 105 and a portion of signal wiring 105' depending on the amount of material applied.

Next, the second passivation film 109 of 500 nm in thickness was formed with a light-sensitive polymeric material so as to cover the whole surface of the substrate. The second passivation film 109 is not particularly limited either and can be selected from a broad range of materials similarly to Example 1. Next, the second passivation film 109 was exposed to light and developed to form the through-hole 404 so as to remove the portion on the picture electrode 401. When the second passivation film 109 is not a light-sensitive material, the through-hole 404 is formed by photolithography method by use of a resist.

Lastly, a polyimide film of 300 nm in thickness was formed on the entire substrate and subjected to rubbing treatment to form the orientated film 405 for liquid crystal. A thin film transistor substrate for liquid crystal display was produced by the above procedures. The thin film transistor in accordance with the present invention can be applied to not only the substrate for liquid crystal display in the present Example but also a wide range of active-matrix displays such as organic electro luminescent display, electrophoretic display and the like.

In the present Example, the thin film transistor of the same structure as in Example 1 was applied to the display, but a thin film transistor of the same structure as in Example 2 or Example 3 can also be used.

It should be further understood by those skilled in the art that although the foregoing description has been made on embodiments of the invention, the invention is not limited thereto and various changes and modifications may be made without departing from the spirit of the invention and the scope of the appended claims.

### Advantages of the Invention

By the present invention, a semiconductor device such as display or IC tag using as a switching element an organic thin film transistor which can be formed by printing can be provided at a low cost.

## Claims

1. A thin film transistor composed of members, on a dielectric substrate (101), which are a gate electrode (102), a dielectric film (103), source/drain electrodes (104, 105), and a semiconductor layer (107), wherein on said semiconductor layer (107) there are provided at least two passivation films (108, 109), one of which is a first passivation film (108) capping said semiconductor layer (107) and another of which is a second passivation film (109) covering larger area than that of said first passivation film (108).

2. The transistor of claim 1, wherein said first passivation film (108) has been formed by dropping of liquid drops or contact printing/heat printing.

3. A process for preparing a thin film transistor, comprising the steps of:
(a) forming a gate electrode (102) on a dielectric substrate (101),
(b) forming a gate dielectric film (103) on the substrate (101) after step (a),
(c) forming a drain electrode (105) and a source electrode (104) on the substrate (101) after step (b),
(d) forming an organic semiconductor by an application method or a printing method on the substrate (101) after step (c),
(e) forming a first passivation film (108) capping said organic semiconductor by dropping of liquid drops or contact printing/heat printing on the substrate (101) after step (d), and
(f) forming a second passivation film (109) in order to protect all of the above members on the substrate (101) after step (e).

4. A process for preparing a thin film transistor, comprising the steps of
(a) forming a gate electrode (102) on a dielectric substrate (101),
(b) forming a gate dielectric film (103) on the substrate (101) after step (a),
(c) forming an organic semiconductor by an application method or a printing method on the substrate (101) after step (b),
(d) forming a drain electrode (105) and a source electrode (104) on the substrate (101) after step (c),
(e) forming a first passivation film (108) capping said organic semiconductor by dropping of liquid drops or contact printing/heat printing on the substrate (101) after step (d), and
(f) forming a second passivation film (109) in order to protect all of the above members on the substrate (101) after step (e).

5. A process for preparing a thin film transistor, which comprises:
(a) forming a drain electrode (105) and a source electrode (104) on a dielectric substrate (101),
(b) forming an organic semiconductor by an application method or a printing method on the substrate (101) after step (a),
(c) forming a first passivation film (108) capping said organic semiconductor by dropping of liquid drops or contact printing/heat printing on the substrate (101) after step (b),
(d) forming a second passivation film (109) in order to protect all of the above members on the substrate (101) after step (c), and
(e) forming a gate electrode (102) on the substrate (101) after step (d).

6. The subject matter of any preceding claim, wherein said first passivation film (108) has a higher adhesion to a groundwork than said semiconductor.

7. The subject matter of any preceding claim, wherein a low molecular weight material is used as said semiconductor and said first passivation film (108) is a water-soluble material.

8. The subject matter of any preceding claim, wherein said first passivation film (108) has a light-sensitive group.

9. The subject matter of any preceding claim, wherein said first passivation film (108) is a polyvinyl alcohol in which an azido light-sensitive group is acetal-bonded.

10. The subject matter of any preceding claim, wherein a material different from said first passivation film (108) is used as said second passivation film (109).

11. The subject matter of any preceding claim, wherein anywhere within the substrate (101) there is no material between said first passivation film (108) and said second passivation film (109).

12. A liquid crystal, electrophoretic or organic electroluminescent (organic LED) display, wherein the transistor of any one of claims 1, 2 and 6 to 11 is used as an active matrix switch.

13. An IC tag device, wherein the transistor of any one of claims 1, 2 and 6 to 11 is used at least partly.

14. A sensor device, wherein the transistor of any one of claims 1, 2 and 6 to 11 is used at least partly.
